# EUROPEAN PATENT APPLICATION

(11) **EP 3 993 569 A1**
(43) Date of publication of application: **04.05.2022**
(21) Application number: 21205238.5
(22) Date of filing: 28.10.2021
(51) Int. Cl.: H05K 1/02, H05K 1/11, H01B 7/04

(54) **FLEXIBLE PRINTED CIRCUIT, FPC, CONNECTING HEAD**

(30) Priority: 28.10.2020 CN 202011172827
(71) Applicant: Shenzhen Startek Electronic, Shenzhen, Guangdong 518000 (CN)
(72) Inventor: ZHU, Dejun, Guangdong, 518000 (CN)
(74) Representative: dompatent von Kreisler Selting Werner - Partnerschaft von Patent- und Rechtsanwälten mbB

(57) **Abstract**

The present invention discloses a flexible printed circuit (FPC) connecting head, including a first insulation layer (5), a first circuit layer (2), a second insulation layer (4), a second circuit layer (6), and a third insulation layer (1) which are disposed in sequence from bottom to top. The first circuit layer (2) is arranged between the first insulation layer (5) and the second insulation layer (4). The second circuit layer (6) is arranged between the second insulation layer (4) and the third insulation layer (1). The first circuit layer (2) is composed of a plurality of conductive strips, foreparts (3) of the plurality of conductive strips are arranged in parallel at equal intervals. A plurality of conductive strips on the second circuit (6) layer pass downwards (7) through the second insulation layer (4) and are correspondingly connected with the plurality of conductive strips on the first circuit layer (2). The FPC connecting head is also provided with a reinforcement plate (8) which is arranged on an underside surface of the first insulation layer (5) or an upper surface of the third insulation layer (1). The FPC connecting head provided by the present invention is simple in structure and convenient to use. A plug-type interface is provided by means of connecting a reinforcement plate at the top or at the bottom, so that the strength of a plugged part is improved, installation and removal are convenient, reuse is realized, the cost is saved, and waste is avoided.

## Description

### TECHNICAL FIELD

The present invention relates to the technical field of electronic connection, in particular to a flexible printed circuit (FPC) connecting head.

### BACKGROUND

With the development of science and technology, devices such as a touch screen and a display screen are developing to be thinner and multi-functional and to have high performance. A flexible printed circuit (FPC) connecting head is used to connect the touch screen and the display screen to a driver circuit board (printed circuit board assemby, PCBA), which is crucial to ensure safe and reliable operation of the touch screen and the liquid crystal screen.

A traditional display screen and touch screen use a welded FPC. Due to the limitations of the production process, a PIN pitch of this type of FPC is greater than or equal to 0.8 mm, and a specific width cannot accommodate more PINs(usually 37 PINs). It is impossible to realize coexistence of various interfaces. In addition, during welding to a main board, The FPC welding part is easy to damage and cannot be re-used, which causes a great waste and inconvenient maintenance. It can be seen that the current FPC obviously cannot meet the development requirements of the display screen and the touch screen.

### SUMMARY

The present invention aims to provide a flexible printed circuit (FPC) connecting head which is simple in structure and convenient to use. A plug interface is provided by means of connecting a reinforcement plate at the top or at the bottom, so that the strength of a plugged part is improved, installation and removal are convenient, reuse is realized, the cost is saved, and waste is avoided.

In order to achieve the above-mentioned purpose, the present invention provides the following solution.

A flexible printed circuit, FPC, connecting head includes a first insulation layer, a first circuit layer, a second insulation layer, a second circuit layer, and a third insulation layer which are disposed in sequence from bottom to top. The first circuit layer is arranged between the first insulation layer and the second insulation layer. The second circuit layer is arranged between the second insulation layer and the third insulation layer. The first circuit layer is composed of a plurality of conductive strips. foreparts of the plurality of conductive strips are arranged in parallel at equal intervals. A plurality of conductive strips on the second circuit layer pass downwards through the second insulation layer and are correspondingly connected with the plurality of conductive strips on the first circuit layer. The FPC connecting head is also provided with a reinforcement plate.

The reinforcement plate is arranged on an underside surface of the first insulation layer. Gold is plated or deposited on upper surfaces of the foreparts of the conductive strips of the first circuit layer to form metal layers. The foreparts of the conductive strips and the metal layers form metal fingers. The reinforcement plate is correspondingly located on the underside of the first insulation layer right below the metal fingers. The metal fingers including the foreparts of the first circuit layer, the first insulation layer, and the reinforcement plate all overlap each and beyond the front ends of the second insulation layer, the second circuit layer, and the third insulation layer.

Or, the reinforcement plate is arranged on an upper surface of the third insulation layer. Gold is plated or deposited on the underside surfaces of the foreparts of the conductive strips of the first circuit layer to form metal layers. The foreparts of the conductive strips and the metal layer form metal fingers. The reinforcement plate is correspondingly located on the upper surface of the third insulation layer right above the backside of the metal fingers. The metal fingers including the foreparts of the first circuit layer, the second insulation layer, the third insulation layer, and the reinforcement plate all overlap each other and extend beyond the front ends of the first insulation layer.

Further, a plurality of vias are arranged on the second insulation layer. The plurality of conductive strips on the second circuit layer respectively pass through the corresponding vias and are correspondingly connected with the plurality of conductive strips on the first circuit layer.

According to the specific technical solutions provided by the present invention, compared with the existing technical solutions, the present invention discloses the following technical effects. According to the FPC connecting head provided by the present invention, the first insulation layer, the second insulation layer, and the third insulation layer insulate and protect the first circuit layer and the second circuit layer respectively. The first insulation layer, the first circuit layer, the second insulation layer, the second circuit layer, and the third insulation layer are in close fit, which can realize light and thin structure design and the good bending property, and the FPC connecting head is suitable for miniaturized, light and thin electronic products. Electrical connection between the first circuit layer and the second circuit layer is realized through the vias, and multilayer high-density wiring can be realized. The reinforcement plate is provided at the upperside part or the underside part to strengthen a plugged part, which can make plug-in and plug-out easier.. The foreparts of the conductive strips and the metal layers form the metal fingers, so that the unit width is reduced and more PINs can be accommodated and coexistence of various interfaces and plugging can be realized. Plug and unplug are convenient, time and labor are saved, and reuse is realized. The damages of an interface due to welding and waste caused by un-re-using are avoided.

### BRIEF DESCRIPTION OF THE DRAWINGS

In order to describe the embodiments of the present invention or technical solutions in the existing art more clearly, drawings required to be used in the embodiments will be briefly introduced below. Apparently, the drawings in the descriptions below are only some embodiments of the present invention. Those ordinarily skilled in the art also can acquire other drawings according to these drawings without creative work.
Fig. 1 is a schematic exploded structural diagram of a flexible printed circuit (FPC) connecting head in Embodiment I of the present invention;
Fig. 2 is a schematic exploded structural diagram of a flexible printed circuit (FPC) connecting head in Embodiment II of the present invention; and
Fig. 3 is a schematic structural diagram of a first circuit layer of the present invention.

Reference signs in the drawings: 1: third insulation layer; 2: first circuit layer; 3: metal finger; 4: second insulation layer; 5: first insulation layer; 6: second circuit layer; 7: vias; and 8: reinforcement plate.

### DETAILED DESCRIPTION

The technical solutions in the embodiments of the present invention will be clearly and completely described below in conjunction with the accompanying drawings in the embodiments of the present invention. Apparently, the described embodiments are only a part of the embodiments of the present invention, rather than all the embodiments. Based on the embodiments in the present invention, all other embodiments obtained by those of ordinary skill in the art without creative work shall fall within the protection scope of the present invention.

The present invention aims to provide a flexible printed circuit (FPC) connecting head for display screen and touch screen devices, which are simple in structure and convenient to use and can realize coexistence of various interfaces. Furthermore, by the arrangement of a plug structure, the FPC connecting head is convenient to install and remove and can be reused, so that the cost is saved, and the waste is avoided.

In order to make the above-mentioned purposes, characteristics and advantages of the present invention more obvious and understandable, the present invention is further described in detail below with reference to the accompanying drawings and specific implementation modes.

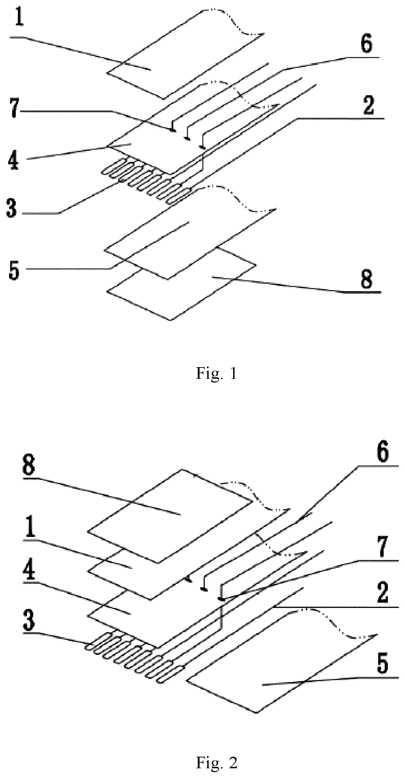

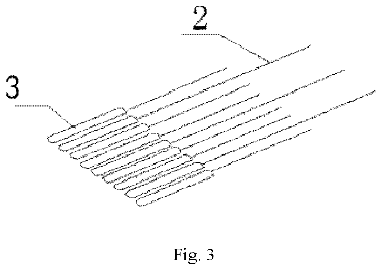

As shown in Fig. 1 to Fig. 3, a FPC connecting head provided by the present invention includes a first insulation layer 5, a first circuit layer 2, a second insulation layer 4, a second circuit layer 6, and a third insulation layer 1 which are disposed in sequence from bottom to top. The first circuit layer 2 is arranged between the first insulation layer 5 and the second insulation layer 4. The second circuit layer 6 is arranged between the second insulation layer 4 and the third insulation layer 1. The first circuit layer 2 is composed of a plurality of conductive strips. foreparts of the plurality of conductive strips are arranged in parallel at equal intervals. A plurality of conductive strips on the second circuit layer 6 pass downwards through the second insulation layer 4 and are correspondingly connected with the plurality of conductive strips on the first circuit layer 2. The FPC connecting head is also provided with a reinforcement plate 8.

In Embodiment I, as shown in Fig. 1, the reinforcement plate 8 is arranged on an underside surface of the first insulation layer 5. Gold is plated or deposited on upper surfaces of the foreparts of the conductive strips of the first circuit layer 2 to form metal layers. The foreparts of the conductive strips and the metal layers form metal fingers 3. The reinforcement plate 8 is correspondingly located on the underside of the first insulation layer right below the metal fingers 3. The metal fingers including the foreparts of the first circuit layer 2, the foreparts of the first insulation layer 5, and the reinforcement plate 8 all overlap each other and extend beyond front ends of the second insulation layer 4, the second circuit layer 6, and the third insulation layer 1.

In Embodiment II, as shown in Fig. 2, the reinforcement plate 8 is arranged on an upper surface of the third insulation layer 1. Gold is plated or deposited on the underside surfaces of the foreparts of the conductive strips of the first circuit layer 2 to form metal layers. The foreparts of the conductive strips and the metal layer form metal fingers 3. The reinforcement plate 8 is correspondingly located on the third layer right above the backside of the metal fingers 3. The metal fingers including the foreparts of the first circuit layer 2, the second insulation layer 4, the third insulation layer 1, and the reinforcement plate 8 all overlap each other and extend beyond front ends of the first insulation layer 5.

In the above-mentioned two embodiments, a plurality of vias 7 are arranged in the second insulation layer 4. The plurality of conductive strips on the second circuit layer 6 respectively pass through the corresponding vias 7 and are correspondingly connected with the plurality of conductive strips on the first circuit layer 2.

In addition, in Embodiment I or Embodiment II, a plurality of second insulation layers 4 may be provided. The upper surface of each second insulation layer 4 is provided with the second circuit layer 6 composed of the plurality of conductive strips. Each conductive strip on the second circuit layer 6 corresponding to each second insulation layer 4 is provided with a vias 7. The plurality of conductive strips on the second circuit layers respectively pass through the corresponding vias 7 and are connected with the plurality of conductive strips on the first circuit layer 2.

The conductive strip may be made of gold, nickel, copper, tin, silver, aluminum or graphene. A PIN distance between two adjacent metal fingers on the first circuit layer 2 is 0.3 mm to 1.0 mm. Since the Pin distance decreases, a fixed length can accommodate more PINs to facilitate reserving various interfaces such MCU, RGB, SPI, MIPI, LVDS, IIC, USB, Edp,etc. Meanwhile, a touch screen interface and a backlight interface can also be integrated.

The first insulation layer 5, the first circuit layer 2, the second insulation layer 4, the second circuit layer 6 and the third insulation layer 1 can be fitted to the reinforcement plate 8 through a thermosetting adhesive and hot pressing. The hot pressing of the thermosetting adhesive can enhance the connection intensity between the first insulation layer 5, the first circuit layer 2, the second insulation layer 4, the second circuit layer 6 as well as the third insulation layer 1 and the reinforcement plate 8. The first insulation layer 5, the second insulation layer 4, and the third insulation layer 1 are all made of a PI material or a PET material, and PI or PET have the high insulation property.

A touch screen or display screen can apply the above-mentioned FPC connecting head. The FPC connecting head may not be necessarily welded on a main board, but can be directly plugged into a socket of a circuit board to get power and signal for the touch screen or display screen Electric energy and signals are acquired to ensure safe and reliable operation of the touch screen or display screen, since it is pluggable and unpluggable, the maintenance and reusing becomes convenient
According to the FPC connecting head provided by the present invention, the first insulation layer, the second insulation layer, and the third insulation layer insulate and protect the first circuit layer and the second circuit layer respectively. The first insulation layer, the first circuit layer, the second insulation layer, the second circuit layer, and the third insulation layer are in close fit, which can realize light and thin structure design and the good bending property, and the FPC connecting head is suitable for miniaturized, light and thin electronic products. Electrical connection between the first circuit layer and the second circuit layer is realized through the vias, and multi-layer high-density wiring can be realized. The reinforcement plate is provided at the upper side or the underside to strengthen a plugged part, which can improve the stability of the FPC connecting head. The foreparts of the conductive strips and the metal layers form the metal fingers, so that coexistence of various interfaces and plugging can be realized. Installation and removal are convenient, time and labor are saved, and reuse is realized. The problems of damage due to welding and waste of the components are avoided.
The principle and implementation modes of the present invention are described by applying specific examples herein. The descriptions of the above embodiments are only intended to help to understand the method of the present invention and a core idea of the method. In addition, those ordinarily skilled in the art can make changes to the specific implementation modes and the application scope according to the idea of the present invention. From the above, the contents of the specification shall not be deemed as limitations to the present invention.

## Claims

1. A flexible printed circuit, FPC, connecting head, is comprising a first insulation layer (5), a first circuit layer (2), a second insulation layer (4), a second circuit layer (6), and a third insulation layer (1) which are disposed in sequence from bottom to top, wherein the first circuit layer (2) is arranged between the first insulation layer (5) and the second insulation layer (4); the second circuit layer (6) is arranged between the second insulation layer (4) and the third insulation layer (1); the first circuit layer (2) is composed of a plurality of conductive strips; foreparts of the plurality of conductive strips are arranged in parallel at equal intervals; a plurality of conductive strips on the second circuit layer (6) pass downwards through the second insulation layer (4) and are correspondingly connected with the plurality of conductive strips on the first circuit layer (2); wherein the flexible printed circuit, FPC, connecting head further comprises a reinforcement plate (8); the reinforcement plate (8) is arranged on an underside surface of the first insulation layer (5); gold is plated or deposited on the upper surfaces of the foreparts of the conductive strips of the first circuit layer (2) to form metal layers; the foreparts of the conductive strips and the metal layers form metal fingers (3); the reinforcement plate (8) is correspondingly located on the underside of the first insulation layer(5) right below the metal fingers (3); the metal fingers (3) including the foreparts of the first circuit layer (2), the first insulation layer (5), and the reinforcement plate (8) all overlap each other and extend beyond front ends of the second insulation layer (4), the second circuit layer (6), and the third insulation layer (1); or, the reinforcement plate (8) is arranged on an upper surface of the third insulation layer (1); gold is plated or deposited on the underside surfaces of the foreparts of the conductive strips of the first circuit layer (2) to form metal layers; the metal layers and the foreparts of the conductive strips form the metal fingers (3); the reinforcement plate (8) on the upper surface of the third insulation layer is located right above backside of the metal fingers (3); and the metal fingers (3) including the foreparts of the first circuit layer (2), the second insulation layer (4), the third insulation layer (1) and the reinforcement plate (8) all overlap each other and extend beyond the front ends of the first insulation layer (5).

2. The flexible printed circuit, FPC, connecting head according to claim 1, wherein a plurality of vias (7) are arranged in the second insulation layer (4); the plurality of conductive strips on the second circuit layer (6) respectively pass through the corresponding vias (7) and are correspondingly connected with the plurality of conductive strips on the first circuit layer (2).
